Europäisches Patentamt

European Patent Office

Office européen des brevets

(11) Publication number: **0 188 378**

**B1**

(12) **EUROPEAN PATENT SPECIFICATION**

(45) Date of publication of patent specification: 21.03.90

(51) Int. Cl.⁵: **G 05 F 3/20**

(21) Application number: 86300240.8

(22) Date of filing: 15.01.86

(54) Semiconductor circuit device.

(30) Priority: 16.01.85 JP 5333/85

(43) Date of publication of application:
23.07.86 Bulletin 86/30

(45) Publication of the grant of the patent:
21.03.90 Bulletin 90/12

(84) Designated Contracting States:
DE FR GB

(56) References cited:
EP-A-0 024 903
US-A-3 794 862

PATENTS ABSTRACTS OF JAPAN, vol. 6, no. 107 (E-113)985r, 17th June 1982; & JP - A - 57 39 566

IEEE JOURNAL OF SOLID-STATE CIRCUITS, vol. SC-15, no. 5, October 1980, pages 839-846, IEEE, New York, US; J.Y. CHAN et al.: "A 100 ns 5 V only 64K x 1 MOS dynamic RAM"

(73) Proprietor: FUJITSU LIMITED
1015, Kamikodanaka Nakahara-ku
Kawasaki-shi Kanagawa 211 (JP)

(72) Inventor: Miyashita, Takumi
Hiraojutaku 42-104 372, Hirao
Inagi-shi Tokyo 192-02 (JP)

(74) Representative: Bedggood, Guy Stuart et al
Haseltine Lake & Co. Hazlitt House 28
Southampton Buildings Chancery Lane
London WC2A 1AT (GB)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

The present invention relates to a semiconductor circuit device formed by a plurality of metal oxide semiconductor (MOS) transistors. More particularly, it relates to a large scale integrated circuit (LSI) having a circuit structure which can prevent bonding pads on the MOS LSI chip being subjected to an electrolytic corrosion action caused by moisture in or the water content of the atmosphere.

As is well-known, an N-channel MOS transistor is, in general, constituted by a p-type substrate, $n^+$ diffusion regions formed in the substrate, and aluminum (Al) electrodes. These electrodes are connected to input or output pads (Al pads) on a semiconductor chip. In this case, generally one end of a gold wire is bonded to the Al pad and the other end of the gold wire is connected to an external terminal of a lead frame of the LSI package which encapsulates the semiconductor chip.

In the LSI chip, particularly an LSI chip constituted by a plastic package, when moisture in or the water content of the atmosphere sinks into the LSI chip through a very narrow gap between the plastic mold and the lead frame, in this case, a kind of "battery" is formed between the bonding pad (anode side) and the substrate electrode or the LSI chip stage (cathode side) based on a difference in the tendency toward ionization caused by the moisture or water content acting as an electrolyte. In this case, since a large current flows from the p-type substrate to the bonding pad through the $n^+$ diffusion region, the bonding pad is gradually corroded by this large current caused by the "battery". Consequently, contact faults occur between the gold wire and the bonding pad.

Moreover, this electrolytic corrosion action frequently occurs in the MOS transistor type that is activated by a back gate voltage to the substrate. This is because the substrate potential gradually rises when the back gate voltage is cut off, so that the threshold voltage of the MOS transistor rises and the input/output MOS transistor for preventing electrostatic breakdown is turned ON, and then the large electrolytic corrosion current flows from the substrate to the bonding pad.

Accordingly, it is desirable to provide a semiconductor circuit device having a circuit structure which can prevent bonding pads from being subjected to an electrolytic corrosion action caused by moisture in or water content of the atmosphere.

JP—A—57-39566 discloses a clamping circuit for clamping the substrate potential of an operating MOS IC. A series of n diode-connected MOS transistors is connected between a ground terminal and the substrate, with their commonly-connected gates and drains on the ground terminal side, such that during operation the negative substrate potential is limited to n times the drain-source voltage of each transistor.

EP—A—0 024 903 by the present applicant discloses a MIS IC having a substrate bias generating circuit which incorporates a clamping circuit. The clamping circuit is provided by a series of diode-connected MOS transistors connected as in JP—A—57-39566, whereby during operation a current flows in a loop formed by the bias circuit and clamping circuit, so as to determine a maximum negative potential of the substrate.

Neither document discloses anything about the above-mentioned problem of electrolytic corrosion action arising when a back gate voltage (substrate bias voltage) is cut off.

According to the present invention, there is provided a semiconductor circuit device comprising:

a semiconductor substrate;

a plurality of metal oxide semiconductor transistors formed on said semiconductor substrate;

a plurality of ground side power source lines formed on said semiconductor substrate; and

a back gate bias generating circuit, formed between said semiconductor substrate and said ground side power source lines, for supplying a back gate voltage to said semiconductor substrate; and characterised by:

a clamp circuit consisting of a MOS diode formed by a MOS transistor having a source connected to one of said ground side power source lines, having a gate, and having a drain, said gate and said drain being connected to said semiconductor substrate, whereby said MOS diode turns ON when the potential of said semiconductor substrate exceeds the potential on said ground side power source lines, so that a current flows from said semiconductor substrate to said ground side power source lines for clamping a potential of said semiconductor substrate to a predetermined level when said back gate bias generating circuit is not operated.

Reference is made, by way of example, to the accompanying drawings in which:—

Figure 1 is a sectional view of a conventional semiconductor circuit device;

Figure 2 is a typical input circuit of a conventional MOS transistor circuit;

Figure 3 is a typical output circuit of a conventional MOS transistor circuit;

Figure 4 is a basic circuit of a back gate bias generating circuit;

Figure 5 is a clamp circuit according to an embodiment of the present invention;

Figure 6 is an input circuit having a clamp circuit as shown in Figure 5;

Figure 7 is an output circuit having a clamp circuit as shown in Figure 5;

Figure 8A is a plan view of a clamp circuit according to an embodiment of the present invention;

Figure 8B is a sectional view taken along the line A—A' of Figure 8A;

Figure 9A is a plan view of an input circuit according to an embodiment of the present invention;

Figure 9B is a sectional view taken along the line B—B' of Figure 9A;

Figure 10A is a plan view of an output circuit according to an embodiment of the present invention;

Figure 10B is a sectional view taken along the line C—C' of Figure 10A; and,

Figure 11 is a perspective partial view of the semiconductor circuit device according to an embodiment of the present invention.

Before describing the preferred embodiments, an explanation will be given of a conventional semiconductor circuit device formed by a plurality of MOS transistors.

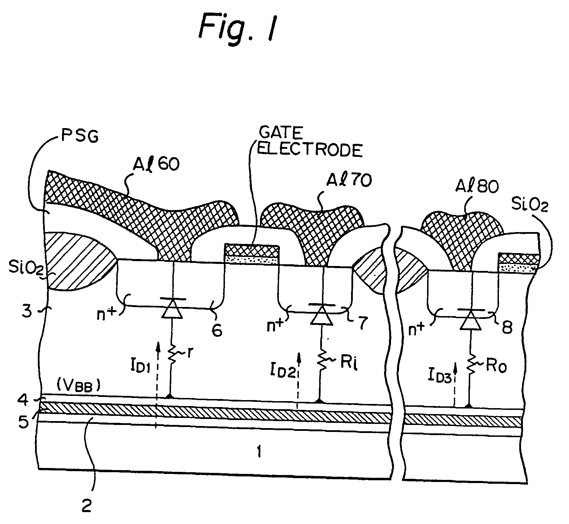

Referring to Figure 1, reference number 1 represents a stage of a lead frame, 2 a gold (Au) plating layer on the stage 1, 3 a p-type silicon (Si) substrate, 4 a substrate electrode having an Au evaporation layer, and 5 an Au-Si solder for bonding the chip 3 to the stage 1. Reference numbers 6, 7, and 8 are $n^+$ diffusion regions.

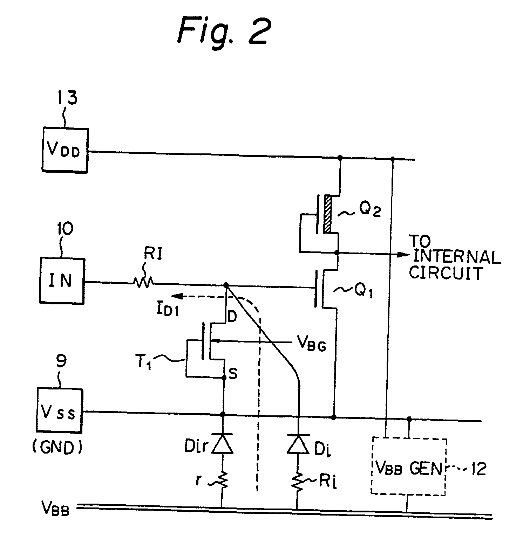

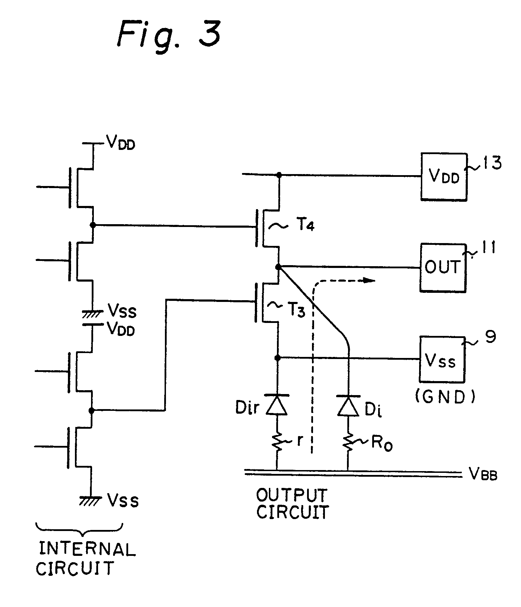

As is well-known, aluminum electrodes 60, 70, and 80 are provided on the $n^+$ diffusion regions 6, 7, and 8 and gate electrodes are provided on the silicon oxide film $(SiO_2)$ shown by a dotted area. In Figure 2, the aluminum layer 60 is a ground wiring for supplying the ground voltage to the inner circuit, and generally, the $n^+$ diffusion region 6 connected to the ground wiring is large enough to allow a large current to flow therein. On the other hand, the other $n^+$ diffusion regions 7, 8 are relatively small regions which are connected to the aluminum electrodes 70, 80, for example. In the p-n junction shown in Figure 1, an internal resistance $r$ in the substrate 3 is relatively small (about several tens of ohms) because the corresponding p-n junction area is wide, as shown by reference number 6. The other internal resistance $R_i(R_0)$ is large (about several hundreds of ohms) because the corresponding p-n junction area is narrower than that of the resistance $r$. Accordingly, the large electrolytic corrosion current $I_{D1}$ mainly flows from the substrate electrode 4 or Au plating layer 2 to the bonding pad (see Figure 2) connected to the Al electrode through the p-type substrate 3 and $n^+$ diffusion region 6. The other electrolytic corrosion currents $I_{D2}$ and $I_{D3}$ also flow, but these currents are so small that they are considered to be negligible. This electrolytic corrosion current will be explained in detail with reference to Figures 2 and 3.

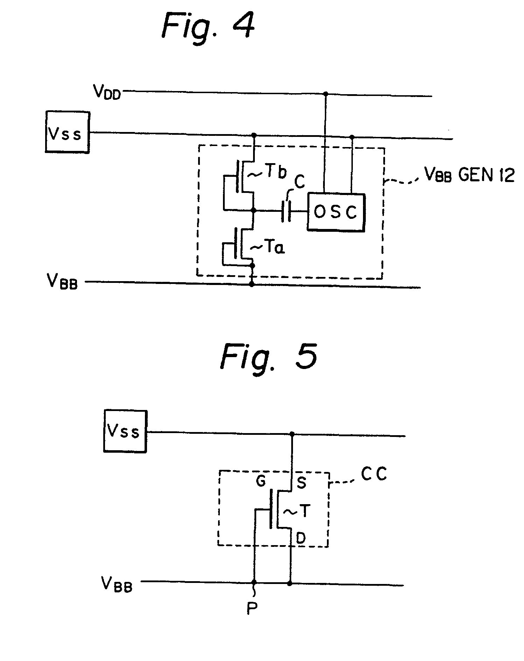

In Figures 2 and 3, reference number 9 represents a bonding pad for a second power source $V_{SS}$ (usually, ground potential), 10 a bonding pad for an input signal, 11 a bonding pad for an output signal, 12 a back gate bias generating circuit $V_{BB}$ GEN for supplying a reference voltage $V_{BB}$ to the substrate 3 in Figure 1, and 13 a bonding pad for a first power source $V_{DD}$. A protection transistor $T_1$ is provided for preventing electrostatic breakdown. The source region of the transistor $T_1$ corresponds to the $n^+$ diffusion region 6 explained in Figure 1 as this source region is connected to the $V_{SS}$ pad 9. The drain region of the transistor $T_1$ corresponds to the $n^+$ diffusion region 7 in Figure 1. $Q_1$ and $Q_2$ are input transistors. The output of this circuit is supplied to an internal circuit (not shown). The back gate bias generating circuit $V_{BB}$ GEN is provided in order to supply the substrate potential (usually, a minus voltage) against the ground (GND) $V_{SS}$ for a proper operation of the MOS transistors. The detailed circuit of the $V_{BB}$ GEN is shown in Figure 4.

As shown in Figure 4, this circuit operates as a so-called charge pump. That is, when the first power source $V_{DD}$ is supplied to the $V_{BB}$ GEN, an oscillator generates a pulse to a capacitor C so that the charges of the substrate are always pulled out to the capacitor C through the transistor $T_a$, and these charges in the capacitor C are always supplied to the ground $V_{SS}$. Consequently, when the $V_{DD}$ is supplied, the substrate potential $V_{BB}$ is maintained at the predetermined constant minus voltage as the reference value.

Problems arise, however, when the first power source $V_{DD}$ is cut OFF, and thus the circuit $V_{BB}$ GEN is rendered inoperative. That is, when the circuit $V_{BB}$ GEN does not operate, the substrate potential $V_{BB}$ gradually rises because the substrate is in a floating state and the charges of the substrate cannot be pulled out therefrom. Accordingly, the back gate voltage $V_{BG}$ of the MOS transistor $T_1$ is raised, so that the threshold level of the MOS transistor becomes low, and then the transistor $T_1$ is turned ON. Consequently, the large electrolytic corrosion current $I_{D1}$ flows from the substrate 3 to the input pad 10 through the internal resistance $r$, the junction diode Dir, and the protection transistor $T_1$. This corrosion current causes a gradual corrosion of the bonding pad which destroys the contact between the pad and the wire. In Figure 3, similarly, the output transistor $T_3$ is turned ON so that the large electrolytic corrosion current flows from the substrate 3 to the output pad 11 through the internal resistance $r$, the junction diode Dir, and the output transistor $T_3$, causing a gradual corrosion of the output pad.

A semiconductor circuit device according to an embodiment of the present invention will be explained in detail below.

Figure 5 is a clamp circuit according to an embodiment of the present invention. Referring to Figure 5, a clamp circuit CC comprises only one MOS transistor T (MOS diode) having a source S connected to the ground $V_{SS}$ and a gate G and drain D connected to the substrate at point P.

When the back gate bias generating circuit $V_{BB}$ GEN shown in Figure 4 is operated, this clamp circuit CC is not activated because the substrate potential $V_{BB}$ is maintained at a lower level than the ground potential $V_{SS}$, so that the transistor T is cut OFF.

When the back gate bias circuit $V_{BB}$ GEN does not operate, the substrate potential $V_{BB}$ gradually rises so that the transistor T is turned ON, because the gate voltage of the transistor T becomes high and the threshold level per se becomes relatively low. Accordingly, the $V_{SS}$ and $V_{BB}$ are short-circuited through the transistor T so that the voltage $V_{SS}$ becomes almost equivalent to the voltage $V_{BB}$. In this case, the protection transistor $T_1$ is not turned ON because the threshold voltage of transistor $T_1$ is maintained at a relatively high level. Therefore, the electrolytic corrosion current $I_{D1}$ shown in Figure 2 no longer flows from the substrate to the bonding pad 10.

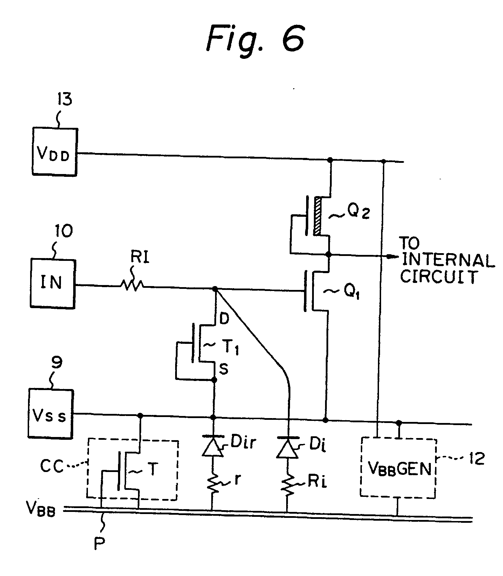

Referring to Figure 6, the clamp circuit CC consisting of the MOS diode is provided between the ground $V_{SS}$ and the substrate $V_{BB}$. Accordingly, when the back gate bias circuit $V_{BB}$ GEN does not operate, since the clamp circuit CC begins to operate, the electrolytic corrosion current no longer flows because the substrate voltage $V_{BB}$ becomes nearly equal to the ground voltage $V_{SS}$.

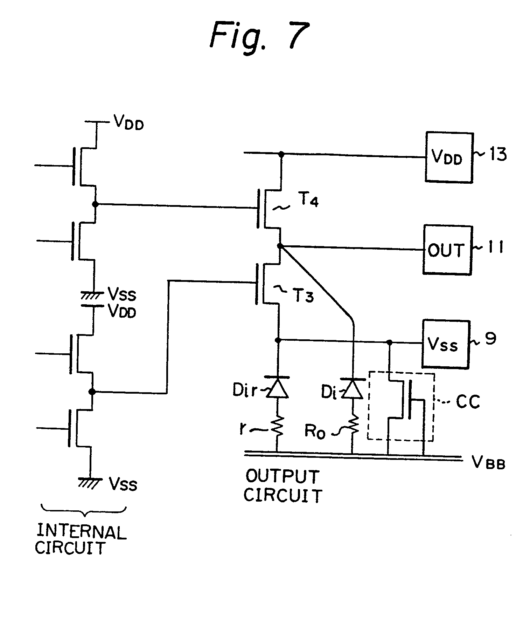

Referring to Figure 7, since the clamp circuit CC is already provided for the input circuit, the electrolytic corrosion current does not flow from the substrate to the output pad 11.

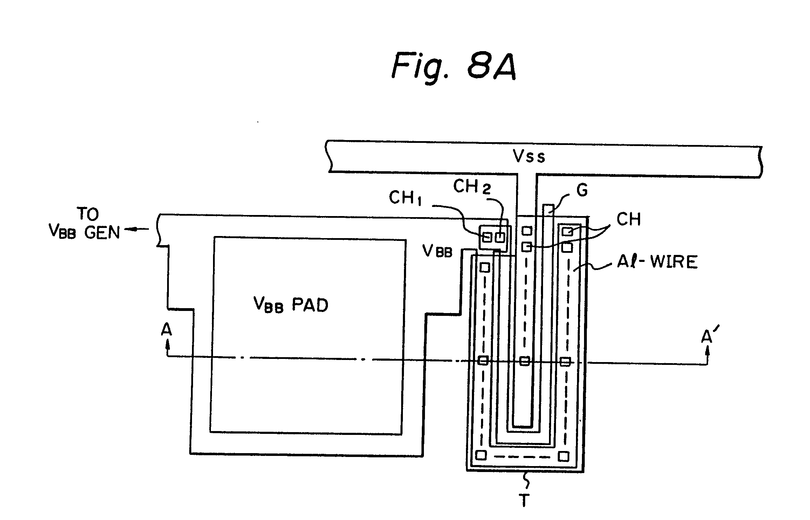

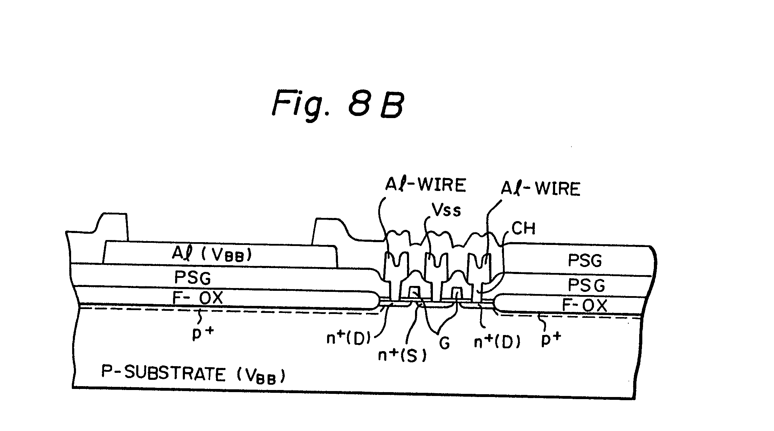

Figure 8A is a plan view of clamp circuit consisting of the MOS diode T based on Figure 5 according to an embodiment of the present invention. Figure 8B is a sectional view taken along the line A—A' of Figure 8A. In Figures 8A and 8B, G is a gate of the transistor T, $n^+(D)$ is a drain of the transistor T formed in the $n^+$ diffusion region, and $n^+(S)$ is a source of the transistor T formed in the $n^+$ diffusion region. CH is a contact holes for connecting between the Al electrode wire ($V_{BB}$ and $V_{SS}$) and $n^+$ diffusion region or the gate of the transistor, PSG is a phosphor-silicate glass layer, and F-OX is a field oxide layer.

In Figure 8A, the contact holes $CH_1$ and $CH_2$ are used for connecting between the substrate voltage aluminum layer $V_{BB}$ and the gate of the transistor T. That is, the contact point P shown in Figure 5 is performed by these contact holes $CH_1$ and $CH_2$.

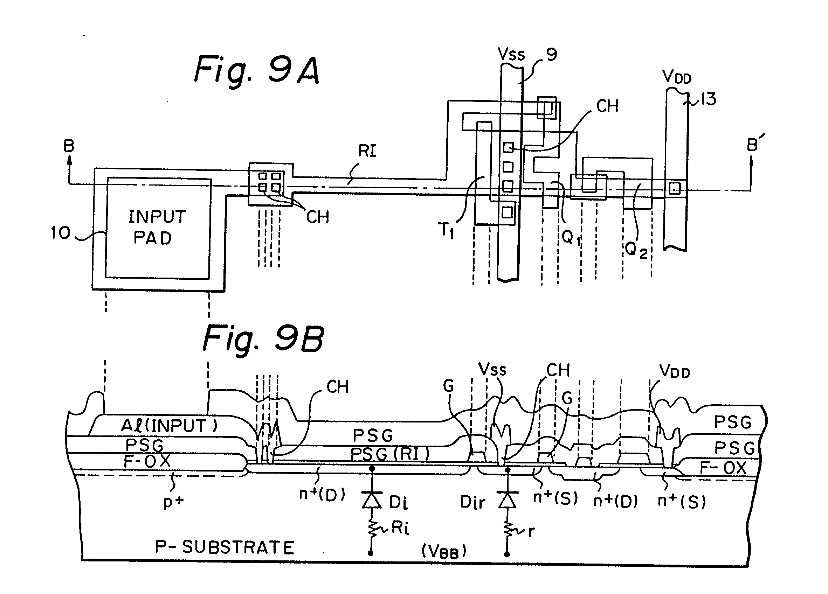

Figure 9A is a plan view of input circuits based on Figure 6 according to an embodiment of the present invention. Figure 9B is a sectional view taken along the line B—B' of Figure 9A. Although the clamp circuit CC is not shown in Figure 9A, Figures 8A and 9A are combined with each other through the ground wiring $V_{SS}$, as is obvious from the circuit shown in Figure 6.

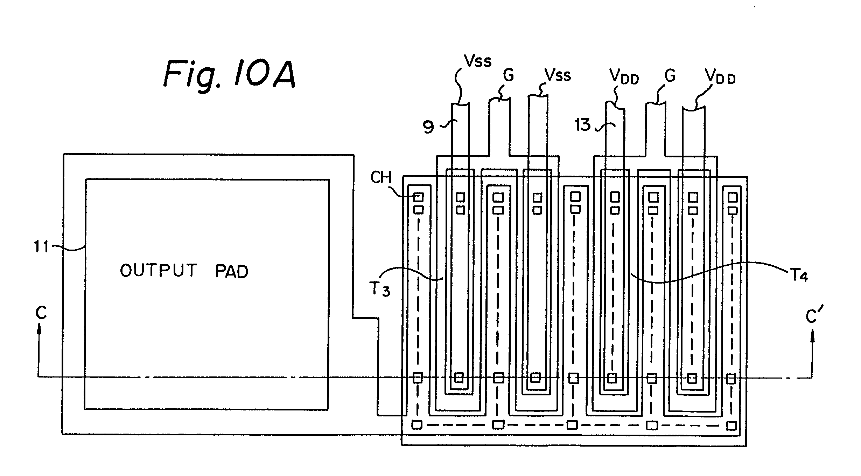

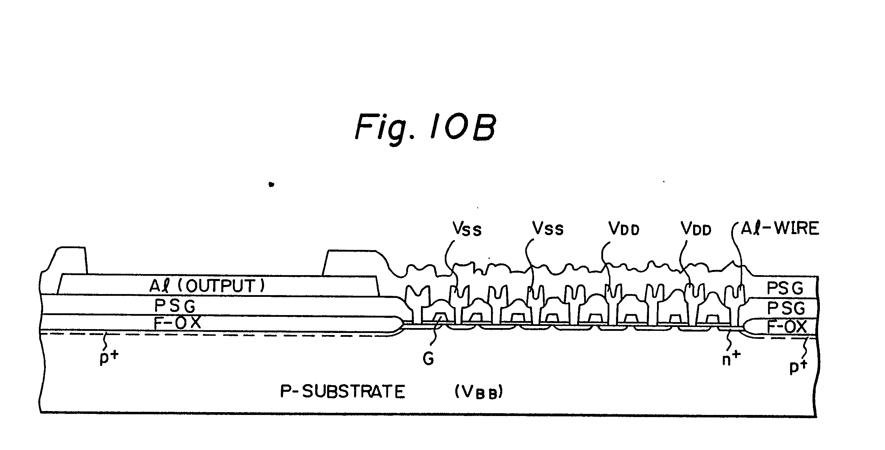

Figure 10A is a plan view of output circuits based on Figure 7 according to an embodiment of the present invention. Figure 10B is a sectional view taken along the line C—C' of Figure 10A.

As is obvious from Figures 8A to 10A, the semiconductor circuit device according to an embodiment of the present invention is constituted by a combination of the circuit shown in Figures 8A to 10A. In this case, an internal circuit (not shown) is omitted because the arbitrary internal circuit can be connected between the input circuit and the output circuit.

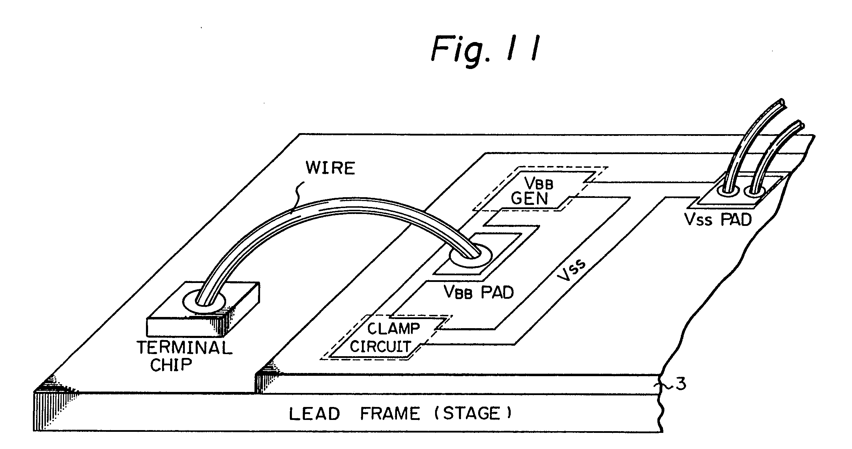

Figure 11 is a perspective view of the structure between the $V_{BB}$ pad and the terminal chip. The $V_{BB}$ pad is connected to the terminal chip by the gold wire. The ground wiring $V_{SS}$ on the substrate 3 is connected from the $V_{SS}$ pad to the clamp circuit and the back gate bias circuit $V_{BB}$ GEN. In Figure 11, the back gate voltage $V_{BB}$ generated by the circuit $V_{BB}$ GEN is provided through the terminal chip which connects between the lead frame stage and the $V_{BB}$ bonding pad on the substrate 3. In another embodiment, the output of the back gate vias circuit $V_{BB}$ GEN is provided directly to the substrate 3 through a well known structure.

## Claims

1. A semiconductor circuit device comprising:
   a semiconductor substrate (3);
   a plurality of metal oxide semiconductor (MOS) transistors formed on said semiconductor substrate;
   a plurality of ground side power source lines ($V_{SS}$) formed on said semiconductor substrate;
   a back gate bias generating circuit (12), formed between said semiconductor substrate (3) and said ground side power source lines ($V_{SS}$), for supplying a back gate voltage ($V_{BB}$) to said semiconductor substrate (3); and characterised by:
   a clamp circuit (CC) consisting of a MOS diode formed by a MOS transistor (T) having a source connected to one of said ground side power source lines ($V_{SS}$), having a gate, and having a drain, said gate and said drain being connected to said semiconductor substrate (3), whereby said MOS diode turns ON when the potential of said semiconductor substrate (3) exceeds the potential on said ground side power source lines ($V_{SS}$), so that a current flows from said semiconductor substrate (3) to said ground side power source lines ($V_{SS}$) for clamping a potential of said semiconductor substrate (3) to a predetermined level when said back gate bias generating circuit (12) is not operated.

2. A semiconductor circuit device as claimed in claim 1, wherein said ground side power source line is supplied with a ground potential.

3. A semiconductor circuit device as claimed in claim 1 or 2, wherein said MOS diode is formed between said semiconductor substrate (3) and said one of said ground side power source lines ($V_{SS}$).

4. A semiconductor circuit device as claimed in claim 1, 2 or 3, wherein said MOS diode is connected between a bonding pad ($V_{BB}$PAD) for supplying said back gate voltage ($V_{BB}$) to said substrate (3), and said one of said ground side power source lines ($V_{SS}$).

## Patentansprüche

1. Halbleiterschaltungsvorrichtung mit:
   einem Halbleitersubstrat (3);
   einer Vielzahl von Metalloxidhalbleiter-(MOS)-Transistoren, die auf dem genannten Halbleitersubstrat gebildet sind;
   einer Vielzahl von erdseitigen Energiequellenleitungen ($V_{SS}$), die auf dem genannten Halbleitersubstrat gebildet sind;
   einer Gegenelektroden-Vorspannungsgeneratorschaltung (12), die zwischen dem genannten Substrat (3) und den genannten erdseitigen Energieversorgungsleitungen ($V_{SS}$) gebildet ist, um eine Gegenelektrodenspannung ($V_{BB}$) an das genannte Halbleitersubstrat (3) zu liefern; und gekennzeichnet durch:

eine Klammerschaltung (CC), die aus einer MOS-Diode besteht, die durch einen MOS-Transistor (T) gebildet ist, der eine Source hat, die mit einer der genannten erdseitigen Energieversorgungsleitungen ($V_{SS}$) verbunden ist, ein Gate hat, und ein Drain hat, welches Gate und welches Drain mit dem genannten Halbleitersubstrat (3) verbunden sind, wodurch die genannte MOS-Diode auf EIN schaltet, wenn das Potential des genannten Halbleitersubstrats (3) das Potential auf den genannten erdseitigen Energieversorgungsleitungen ($V_{SS}$) überschreitet, so daß ein Strom von dem genannten Halbleitersubstrat (3) zu den erdseitigen Energieversorgungsleitungen ($V_{SS}$) fließt, um ein Potential des genannten Halbleitersubstrats (3) auf einem vorbestimmten Pegel zu klammern, wenn die genannte Gegenelektroden-Vorspannungsgeneratorschaltung (12) nicht betrieben wird.

2. Halbleiterschaltungsvorrichtung nach Anspruch 1, bei der die genannte erdseitige Energieversorgungsleitung mit einem Erdpotential versorgt wird.

3. Halbleiterschaltungsvorrichtung nach Anspruch 1 oder 2, bei der die genannte MOS-Diode zwischen dem genannten Halbleitersubstrat (3) und der genannten einen der genannten erdseitigen Energieversorgungsleitungen ($V_{SS}$) gebildet ist.

4. Halbleiterschaltungsvorrichtung nach Anspruch 1, 2 oder 3, bei der die genannte MOS-Diode zwischen einem Anschlußflecken ($V_{BB}$PAD) zur Zuführung der genannten Gegenelektrodenspannung ($V_{BB}$) zu dem genannten Substrat (3) und der genannten einen der genannten erdseitigen Energieversorgungsleitungen ($V_{SS}$) verbunden ist.

**Revendications**

1. Dispositif de circuit à semiconducteur qui comprend:

un substrat semiconducteur (3);

plusieurs transistors métal-oxyde-semiconducteur (MOS) formés sur ledit substrat semiconducteur;

plusieurs lignes d'alimentation côté masse ($V_{SS}$) formées sur ledit substrat semiconducteur;

un circuit (12) de génération de polarisation de grille arrière, formé entre ledit substrat semiconducteur (3) et lesdites lignes d'alimentation côté masse ($V_{SS}$), pour délivrer une tension de grille arrière ($V_{BB}$) audit substrat semiconducteur (3); et caractérisé par:

un circuit de limitation (CC) constitué par une diode MOS formée par un transistor MOS (T) ayant une source reliée à l'une desdites lignes d'alimentation côté masse ($V_{SS}$), ayant une grille et ayant un drain, ladite grille et ledit drain étant reliés audit substrat semiconducteur (3), de sorte que ladite diode MOS conduit quand le potentiel dudit substrat semiconducteur (3) dépasse le potentiel sur lesdites lignes d'alimentation côté masse ($V_{SS}$) ce qui fait qu'un courant circule à partir dudit substrat semiconducteur (3) vers lesdites lignes d'alimentation côté masse ($V_{SS}$) afin de limiter un potentiel dudit substrat semiconducteur (3) à un niveau prédéterminé quand ledit circuit (12) de génération de polarisation de grille arriène n'est pas en fonctionnment.

2. Dispositif de circuit à semiconducteur selon la revendication 1, dans lequel ladite ligne d'alimentation côté masse est alimentée par un potentiel de masse.

3. Dispositif de circuit à semiconducteur selon la revendication 1 ou 2, dans lequel ladite diode MOS est formée entre ledit substrat semiconducteur (3) et une desdites lignes d'alimentation côté masse ($V_{SS}$).

4. Dispositif de circuit à semiconducteur selon la revendication 1, 2 ou 3, dans lequel ladite diode MOS est connectée entre un plot de connexion (plot $V_{BB}$) pour fournir ladite tension de grille arrière ($V_{BB}$) audit substrat (3), et une desdites lignes d'alimentation côté masse ($V_{SS}$).

# Fig. I

# Fig. 2

# Fig. 3

# Fig. 4

# Fig. 5

# Fig. 6

# Fig. 7

# Fig. 8A

EP 0 188 378 B1

# Fig. 8B

EP 0 188 378 B1

## Fig. 9A

## Fig. 9B

*Fig. IOA*

OUTPUT PAD

Fig. IOB

Vss   Vss   VDD   VDD (Al-WIRE)

Al (OUTPUT)
PSG
F-OX

PSG
PSG
F-OX

G

p+   n+   p+

P-SUBSTRATE   (VBB)

Fig. 11